# EUROPEAN PATENT SPECIFICATION

(11) **EP 1 695 340 B1**
(45) Date of publication and mention of the grant of the patent: **23.04.2008**
(21) Application number: 04799006.4
(22) Date of filing: 26.11.2004
(51) Int. Cl.: G11B 7/0065, G11C 13/04, G06K 7/10, H04N 3/15

(54) **HOLOGRAPHIC SCANNING DEVICE**
HOLOGRAPHISCHE SCAN-EINRICHTUNG
DISPOSITIF DE BALAYAGE HOLOGRAPHIQUE

(30) Priority: 08.12.2003 EP 03078842; 29.07.2004 EP 04300493
(43) Date of publication of application: 30.08.2006
(73) Proprietor: Koninklijke Philips Electronics N.V., 5621 BA Eindhoven (NL)
(72) Inventor: LIEDENBAUM, Coen, Société Civile SPID, F-75008 PARIS (FR)
(74) Representative: van Oudheusden-Perset, Laure E.
(86) International application number: PCT/IB2004/003904
(87) International publication number: WO 2005/057557

(56) References cited:
- EP-A- 0 669 757
- EP-A- 1 199 614
- WO-A-00/59206
- WO-A-97/12483
- US-B1- 6 249 312
- US-B1- 6 490 061
- US-B1- 6 570 613
- PATENT ABSTRACTS OF JAPAN vol. 016, no. 196 (E-1200), 12 May 1992 (1992-05-12) & JP 04 027264 A (NIDEK CO LTD), 30 January 1992 (1992-01-30)
- PATENT ABSTRACTS OF JAPAN vol. 2002, no. 03, 3 April 2002 (2002-04-03) & JP 2001 309229 A (VICTOR CO OF JAPAN LTD), 2 November 2001 (2001-11-02)

## Description

### FIELD OF THE INVENTION

The present invention relates to an optical holographic device for reading out a data page recorded in a holographic medium, to a method for reading out such a data page and to a computer program for carrying out such a method.

### BACKGROUND OF THE INVENTION

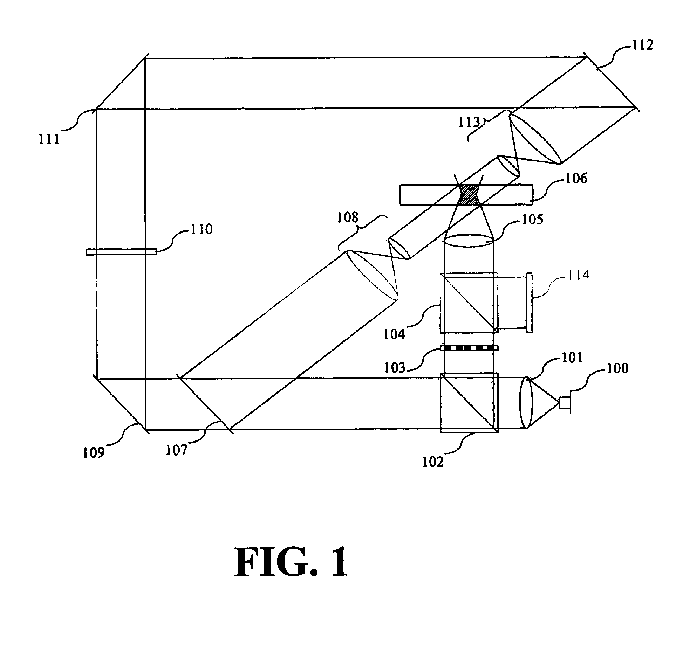

An optical device capable of recording on and reading from a holographic medium is known from H.J. Coufal, D. Psaltis, G.T. Sincerbox (Eds.), 'Holographic data storage', Springer series in optical sciences, (2000). Fig. 1 shows such an optical device. This optical device comprises a radiation source 100, a collimator 101, a first beam splitter 102, a spatial light modulator 103, a second beam splitter 104, a lens 105, a first deflector 107, a first telescope 108, a first mirror 109, a half wave plate 110, a second mirror 111, a second deflector 112, a second telescope 113 and a detector 114. The optical device is intended to record in and read data from a holographic medium 106.

Another holographic data recording/reproducing device is known e.g. from US-B-6 490.061, which is used for the two-part form delimitation. During recording of a data page in the holographic medium, half of the radiation beam generated by the radiation source 100 is sent towards the spatial light modulator 103 by means of the first beam splitter 102. This portion of the radiation beam is called the signal beam. Half of the radiation beam generated by the radiation source 100 is deflected towards the telescope 108 by means of the first deflector 107. This portion of the radiation beam is called the reference beam. The signal beam is spatially modulated by means of the spatial light modulator 103. The spatial light modulator comprises transmissive areas and absorbent areas, which corresponds to zero and one data-bits of a data page to be recorded. After the signal beam has passed through the spatial light modulator 103, it carries the signal to be recorded in the holographic medium 106, i.e. the data page to be recorded. The signal beam is then focused on the holographic medium 106 by means of the lens 105.

The reference beam is also focused on the holographic medium 106 by means of the first telescope 108. The data page is thus recorded in the holographic medium 106, in the form of an interference pattern as a result of interference between the signal beam and the reference beam. Once a data page has been recorded in the holographic medium 106, another data page is recorded at a same location of the holographic medium 106. To this end, data corresponding to this data page are sent to the spatial light modulator 103. The first deflector 107 is rotated so that the angle of the reference signal with respect to the holographic medium 106 is modified. The first telescope 108 is used to keep the reference beam at the same position while rotating. An interference pattern is thus recorded with a different pattern at a same location of the holographic medium 106. This is called angle multiplexing. A same location of the holographic medium 106 where a plurality of data pages is recorded is called a book.

Alternatively, the wavelength of the radiation beam may be tuned in order to record different data pages in a same book. This is called wavelength multiplexing. Other kind of multiplexing, such as shift multiplexing, may also be used for recording data pages in the holographic medium 106.

During readout of a data page from the holographic medium 106, the spatial light modulator 103 is made completely absorbent, so that no portion of the beam can pass trough the spatial light modulator 103. The first deflector 107 is removed, such that the portion of the beam generated by the radiation source 100 that passes through the beam splitter 102 reaches the second deflector 112 via the first mirror 109, the half wave plate 110 and the second mirror 111. If angle multiplexing has been used for recording the data pages in the holographic medium 106, and a given data page is to be read out, the second deflector 112 is arranged in such a way that its angle with respect to the holographic medium 106 is the same as the angle that were used for recording this given hologram. The signal that is deflected by the second deflector 112 and focused in the holographic medium 106 by means of the second telescope 113 is thus the phase conjugate of the reference signal that were used for recording this given hologram. If for instance wavelength multiplexing has been used for recording the data pages in the holographic medium 106, and a given data page is to be read out, the same wavelength is used for reading this given data page.

The phase conjugate of the reference signal is then diffracted by the information pattern, which creates a reconstructed signal beam, which then reaches the detector 114 via the lens 105 and the second beam splitter 104. An imaged data page is thus created on the detector 114, and detected by said detector 114. The detector 114 comprises pixels or detector elements, each detector element corresponding to a bit of the imaged data page. This means that the size of a detector element is approximately equal to the size of an imaged data bit, so that when a data bit impinges on a detector element, the output of the detector element gives an information about the value of said data bit. Other holographic devices are designed in such a way that a data bit impinges on more than one detector elements.

A drawback of such holographic devices is that when the data capacity of the holographic medium increases, the number of pixels of the detector should increase accordingly, because the number of pixels should be at least equal to the number of data bits of a data page. Now, the number of pixels of the detector is limited, because the size and the cost of such a detector drastically increases with the number of pixels. This means that such a holographic device is not able to read a holographic medium with a large data capacity.

### SUMMARY OF THE INVENTION

It is an object of the invention to provide a holographic device which can read a holographic medium with an increased data capacity.

To this end, the invention proposes an optical holographic device for reading out a data page recorded in a holographic medium, said device comprising means for forming an imaged data page from said data page, said imaged data page comprising imaged data bits having a first size in a first direction, means for detecting said imaged data page, said detecting means comprising detector elements having a second size in said first direction, said second size being larger than said first size, and displacement means for displacing the imaged data page in the first direction with respect to the detecting means so as to scan said imaged data page over a distance corresponding to the first size.

According to the invention, more than one imaged data bit impinge on a detector element. As a consequence, the number of detector elements of the detecting means is inferior to the number of data bits of a data page. This allows increasing the number of data bits of a data page without need of increasing the number of detector elements of the detecting means intended to read out said data page. The scanning of the imaged data page by means of the displacement means allows retrieving the values of the data bits, although the number of imaged data bits that impinge on a single detector element is greater than 1.

Advantageously, the displacement means comprise an electrowetting based deflection device or a liquid crystal based deflection device. Such a device can displace a radiation beam by application of a voltage between electrodes. As a consequence, no mechanical means are required for displacing the imaged data page with respect to the detecting means, which reduces the size and the power consumption of the holographic device.

Preferably, the detector elements are disposed in staggered rows, the means for forming an imaged data page being arranged in such a way that an imaged data bit impinges on at least two detector elements. As will be explained in detail in the description, this allows reducing the memory resources required for storing the outputs of the detector elements. Furthermore, subtraction of the outputs of said two detector elements subtracts the background noise, thus improving the signal over noise ratio.

The invention also relates to a method for reading out a data page recorded in a holographic medium, said method comprising a step of forming an imaged data page from said data page on detecting means, said imaged data page comprising imaged data bits having a first size in a first direction, at least one step of displacing the imaged data page with respect to the detecting means over a distance corresponding to the first size, and, after each displacing step, a step of measuring the output of at least one detector element having a second size in said first direction, said second size being larger than said first size, the method further comprising a step of retrieving the data page from said measurements

The invention further relates to a computer program comprising a set of instructions which, when loaded into a processor or a computer, causes the processor or the computer to carry out this method.

These and other aspects of the invention will be apparent from and will be elucidated with reference to the embodiments described hereinafter.

### BRIEF DESCRIPTION OF THE DRAWINGS

The invention will now be described in more detail by way of example with reference to the accompanying drawings, in which :
- Fig. 1 shows a holographic device in accordance with the prior art;
- Fig. 2a and 2b shows a holographic device in accordance with an advantageous embodiment of the invention;
- Figs. 3a to 3d illustrate a method for retrieving data bits in a holographic device in accordance with the invention;
- Figs. 4a to 4d illustrate a method for retrieving data bits in a holographic device in accordance with a preferred embodiment of the invention;

### DETAILED DESCRIPTION OF THE INVENTION

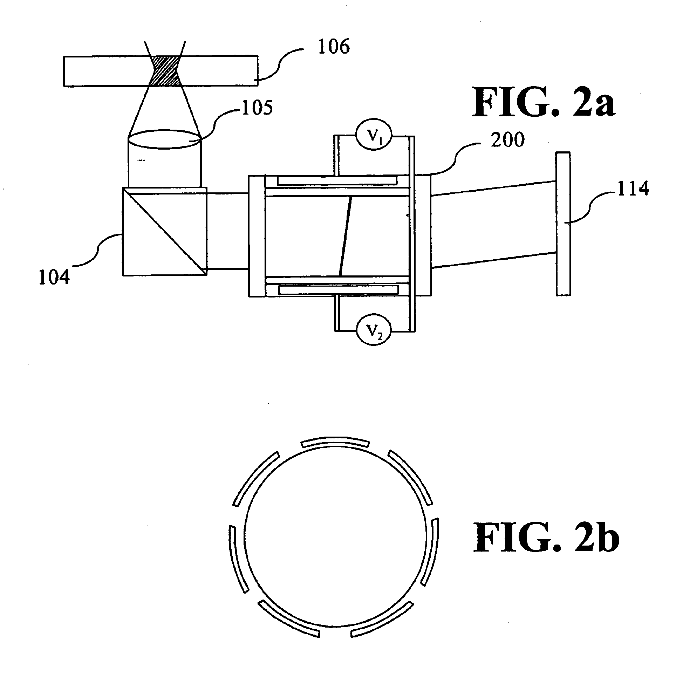

An holographic device in accordance with an advantageous embodiment of the invention is depicted in Figs. 2a and 2b. It comprises the detector 114 for detecting an imaged data page, and an electrowetting device 200. The electrowetting device 200 is placed before the detector 114, so as to displace the imaged data page with respect to the detector 114. In this example, the displacing means are thus the electrowetting device 200. An electrowetting device comprises a fluid chamber and two different fluids separated by a meniscus of which an edge is constrained by the fluid chamber

The electrowetting device 200 is a segmented electrowetting device. Fig. 2b is a cross sectional view of the segmented electrowetting device 200. The segmented electrowetting device 200 comprises a plurality of electrodes. Different voltages may be applied between a given electrode and a common electrode, such as V₁ and V₂ as represented in Fig. 2a. The segmented electrowetting device 200 thus comprises voltage control means for providing a different voltage to a first electrowetting electrode arranged to act on a first side of the edge and to a second electrowetting electrode arranged to act separately on a second side of the edge. Such a segmented electrowetting device 200 is known from patent application WO2004/051323. As explained in this publication, application of different voltages to the first and second electrodes leads to an angular deflection of the radiation beam passing through the segmented electrowetting device 200. It is thus possible to translate the imaged data page with respect to the detector 114 by application of suitable voltages.

Another example of electro-optical device that can be used for displacing the imaged data page with respect to the detector 114 is a liquid crystal based wedge device such as described in patent application US 5,615,029.

Use of such an electro-optical device as displacing means avoids use of mechanical means, which reduces the size, cost and power consumption of the holographic device. However, mechanical means may be used for displacing the imaged data page with respect to the detector 114. For example, the detector 114 may be mounted on a sledge and displaced so as to scan the imaged data page. Alternatively, the imaged data page can be displaced by modification of the angle of the reference beam with respect to the holographic medium 106. This is particularly advantageous when angle multiplexing is used, because no additional displacing means are required. Actually, the displacing means used for modifying the angle of the reference beam so as to switch from one data page to another can be used for displacing a given imaged data page. The imaged data page can also displaced by rotation of the reference and rotation of the holographic medium 106 in such a way that the angle of the reference beam with respect to the holographic medium 106 does not vary.

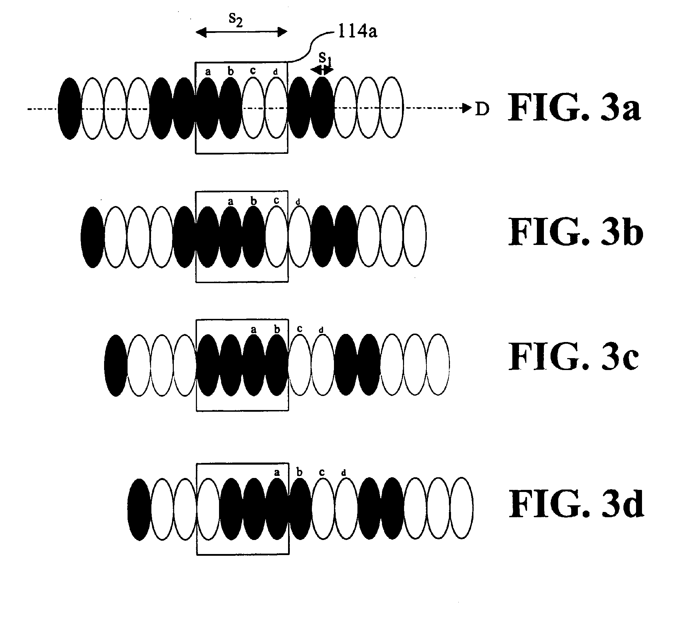

Figs. 3a to 3d illustrate the method in accordance with the invention. In Figs. 3a to 3d, a detector element 114a is shown, as well as a portion of an imaged data page. The imaged data bits have a first size s₁ in a direction D and the detector element 114a has a second size s₂ in said direction D. In this example, the second size s2 is four times larger than the first size s₁. However, the invention is not limited to this ratio. Moreover, this ratio may not be an integer. Preferably, the second size s2 is at least two times larger than the first size s₁, so that the data density of the holographic medium is at least doubled.

In Fig. 3b, the imaged data page has been displaced in the direction D over a distance corresponding to the first size s₁ of an imaged data bit. In other words, an imaged data bit has gone out of the detector element 114a, whereas another imaged data bit has entered the detector element 114a. The method in accordance with the invention consists in measuring the outputs of the detector elements, then displacing the imaged data page with respect to the detector 114, measuring the outputs of the detector elements, and so on until enough measurements have been carried out in order to retrieve all the data bits of the data page.

There are various ways of retrieving the data bits from measurements carried out in accordance with the invention. An example is described hereinafter, with reference to Fig. 3a to 3d. An imaged data bit with a high intensity is represented black and leads to an output intensity equal to 1. An imaged data bit with a low intensity is represented white and leads to an output intensity equal to 0. In Fig. 3a, the output of the detector element 114a is 2, which means that there are two high intensity imaged data bits and two low intensity imaged data bits. In Fig. 3b, the output of the detector element 114a is 3. This means that there are now three high intensity imaged data bits. As a consequence, it can be deduced that the imaged data bit noted d is a low intensity imaged data bit, because a low intensity imaged data bit has gone out the detector element 114a and a high intensity imaged data bit has entered the detector element 114a. In Fig. 3c, the output of the detector element 114a is 4. It can thus be deduced that the imaged data bit noted c is a low intensity imaged data bit. In Fig. 3d, the output of the detector element 114a is 3. It can thus be deduced that the imaged data bit noted b is a high intensity imaged data bit, because a high intensity imaged data bit has gone out the detector element 114a and a low intensity imaged data bit has entered the detector element 114a. As the output of the detector element 114a is 2, it can finally be deduced that the imaged data bit noted a is a high intensity imaged data bit.

Similar measurements are carried out on adjacent detector elements. It is thus possible to retrieve the whole data page. If the second size s₂ of the detector elements is X times larger than the first size s₁ of the imaged data bits, the imaged data page has to be displaced (X-1) times with respect to the detector 114. Instead of measuring the outputs of the detector elements, it is possible to measure the differences between two consecutive outputs of a same detector element. In the example of Figs. 3a to 3d, the differences +1, +1, -1 would consecutively be measured. In this case, at least one additional measure needs to be taken into account. It can be for instance the differences measured for an adjacent detector element.

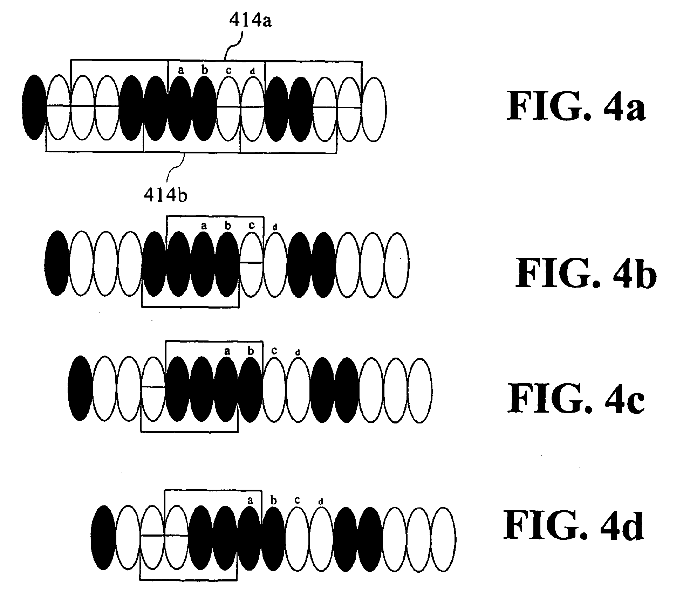

Figs. 4a to 4d illustrate a method in accordance with a preferred embodiment of the invention. In the preferred embodiment, the detector elements are disposed in staggered rows, and an imaged data bit impinges on at least two detector elements. In Fig. 4a to 4d, two particulars detector elements have been noted 414a and 414b. The method in accordance with this preferred embodiment consists in subtracting the outputs of the detector elements having common imaged bits. In this example, detector elements 414a and 414b for example have common imaged data bits noted a, b and c. In Fig. 4a, the difference between the outputs of detector elements 414a and 414b is -1. From this difference, it can be deduced that the imaged data bit noted d is a low intensity imaged data bit. In Fig. 4b, after the imaged data page has been displaced with respect to the detector, the difference between the outputs of detector elements 414a and 414b is -1. Hence the imaged data bit noted c is a low intensity imaged data bit. The preceding steps are repeated until imaged data bits a, b, c and d are retrieved. Similar steps are carried out for the other detector elements, so that the whole data page can be retrieved.

In this preferred embodiment, only differences between detector elements are calculated, and a value of an imaged data bit is deduced from such a difference. As a consequence, there is no need to store the outputs of the detectors, as was the case in the method illustrated in Figs. 3a to 3d. This allows saving memory resources, which is advantageous because a detector may comprise millions of detector elements, and storing millions of outputs requires relatively large memory resources. Moreover, if there is noise in the measures, the noise is reduced by subtraction of the outputs of two adjacent detector elements such as detector elements 414a and 414b. Hence the signal to noise ratio is increased. Noise may be present in the outputs of the detector elements due to for instance noise in the laser source or to the dark current of the detector.

The method for reading out a data page according to the invention can be implemented in an integrated circuit, which is intended to be integrated in an holographic device. A set of instructions that is loaded into a program memory causes the integrated circuit to carry out the method for reading out the data page. The set of instructions may be stored on a data carrier such as, for example, a disk. The set of instructions can be read from the data carrier so as to load it into the program memory of the integrated circuit, which will then fulfil its role.

Any reference sign in the following claims should not be construed as limiting the claim. It will be obvious that the use of the verb "to comprise" and its conjugations does not exclude the presence of any other elements besides those defined in any claim. The word "a" or "an" preceding an element does not exclude the presence of a plurality of such elements.

## Claims

1. An optical holographic device for reading out a data page recorded in a holographic medium (106), said device comprising means (104, 105) for forming an imaged data page from said data page, said imaged data page comprising imaged data bits (a, b, c, d) having a first size (s₁) in a direction (D), means for detecting (114) said imaged data page, **characterized in that** said detecting means comprising detector elements having a second size (s₂) in said direction, said second size being larger than said first size, and displacement means (200) for displacing the imaged data page in said direction with respect to the detecting means so as to scan said imaged data page over a distance corresponding to the first size (s₁)

2. An optical holographic device as claimed in claim 1, wherein the second size is at least two times larger than the first size.

3. An optical holographic device as claimed in claim 1, wherein said displacement means comprise an electrowetting based deflection device (200) or a liquid crystal based deflection device.

4. An optical holographic device as claimed in claim 1, wherein the detector elements (414a, 414b) are disposed in staggered rows, the means for forming an imaged data page being arranged in such a way that an imaged data bit impinges on at least two detector elements.

5. A method for reading out a data page recorded in a holographic medium, said method comprising a step of forming an imaged data page from said data page on detecting means, said imaged data page comprising imaged data bits having a first size in a direction, **characterized in that** there is at least one step of displacing the imaged data page with respect to the detecting means over a distance corresponding to the first size and, after each displacing step, a step of measuring the output of at least one detector element having a second size in said direction, said second size being larger than said first size, the method further comprising a step of retrieving the data page from said measurements.

6. A method for reading out a data page as claimed in claim 5, said method further comprising, after each step of measuring, a step of subtracting the outputs of two detector elements.

7. A method for reading out a data page as claimed in claim 5, wherein said second size is X times larger than said first size, the method comprising (X-1) displacing steps.

8. A computer program comprising a set of instructions which, when loaded into a processor or a computer, causes the processor or the computer to carry out the method as claimed in Claim 5.

## Patentansprüche

1. Optische holographische Einrichtung zum Auslesen einer in einem holographischen Medium (106) aufgezeichneten Datenseite, wobei die Einrichtung umfasst: Mittel (104, 105) zum Bilden einer abgebildeten Datenseite aus der Datenseite, wobei die abgebildete Datenseite abgebildete Datenbits (a, b, c, d) umfasst, die eine erste Größe (s₁) in einer Richtung (D) aufweisen, Mittel zum Detektieren (114) der abgebildeten Datenseite, **dadurch gekennzeichnet, dass** die Detektiermittel Detektorelemente umfassen, die eine zweite Größe (s₂) in dieser Richtung aufweisen, wobei die zweite Größe größer als die erste Größe ist, und Verlagerungsmittel (200) zum Verlagern der abgebildeten Datenseite in der besagten Richtung bezüglich der Detektiermittel, so dass die abgebildete Datenseite über eine Entfernung abgetastet wird, die der ersten Größe (s₁) entspricht.

2. Optische holographische Einrichtung nach Anspruch 1, wobei die zweite Größe mindestens zweimal so groß ist wie die erste Größe.

3. Optische holographische Einrichtung nach Anspruch 1, wobei die Verlagerungsmittel eine auf Elektrobenetzung beruhende Ablenkeinrichtung (200) oder eine auf Flüssigkristall beruhende Ablenkeinrichtung umfassen.

4. Optische holographische Einrichtung nach Anspruch 1, wobei die Detektorelemente (414a, 414b) in gegeneinander versetzten Reihen angeordnet sind, wobei die Mittel zum Bilden einer abgebildeten Datenseite auf eine solche Weise angeordnet sind, dass ein abgebildetes Datenbit auf mindestens zwei Detektorelemente fällt.

5. Verfahren zum Auslesen einer in einem holographischen Medium aufgezeichneten Datenseite, wobei das Verfahren umfasst: einen Schritt des Bildens einer abgebildeten Datenseite aus der Datenseite auf Detektiermitteln, wobei die abgebildete Datenseite abgebildete Datenbits umfasst, die eine erste Größe in einer Richtung aufweisen,
**dadurch gekennzeichnet, dass** mindestens ein Schritt des Verlagerns der abgebildeten Datenseite bezüglich der Detektiermittel über eine Entfernung, die der ersten Größe entspricht, vorhanden ist, und nach jedem Verlagerungsschritt ein Schritt des Messens des Ausgangs mindestens eines Detektorelements, das eine zweite Größe in der besagten Richtung aufweist, wobei die zweite Größe größer als die erste Größe ist, wobei das Verfahren ferner einen Schritt des Wiedergewinnens der Datenseite aus den Messungen umfasst.

6. Verfahren zum Auslesen einer Datenseite nach Anspruch 5, wobei das Verfahren ferner nach jedem Schritt des Messens einen Schritt des Subtrahierens der Ausgänge von zwei Detektorelementen umfasst.

7. Verfahren zum Auslesen einer Datenseite nach Anspruch 5, wobei die zweite Größe X mal so groß ist wie die erste Größe und wobei das Verfahren (X-1) Verlagerungsschritte umfasst.

8. Computerprogramm, das eine Menge von Anweisungen umfasst, welche, wenn sie in einen Prozessor oder einen Computer geladen werden, bewirken, dass der Prozessor oder der Computer das Verfahren nach Anspruch 5 ausführt.

## Revendications

1. Dispositif holographique optique pour lire une page de données enregistrée sur un support holographique (106), ledit dispositif comprenant des moyens (104, 105) pour former une page de données représentée par une image à partir de ladite page de données, ladite page de données représentée par une image comprenant des bits de données, représentés par une image, (a, b, c, d), possédant une première dimension (s₁) dans une direction (D), un moyen pour détecter (114) ladite page de données représentée par une image, **caractérisé en ce que** ledit moyen de détection comprend des éléments détecteurs possédant une seconde dimension (s₂) dans ladite direction, ladite seconde dimension étant plus grande que ladite première dimension, et un moyen de déplacement (200) pour déplacer la page de données représentée par une image dans ladite direction par rapport au moyen de détection, afin de balayer ladite page de données représentée par une image sur une distance correspondant à la première dimension (s₁).

2. Dispositif holographique optique selon la revendication 1, dans lequel la seconde dimension est au moins deux fois plus grande que la première dimension.

3. Dispositif holographique optique selon la revendication 1, dans lequel ledit moyen de déplacement comprend un dispositif de déviation (200) basé sur l'électromouillage ou un dispositif de déviation basé sur des cristaux liquides.

4. Dispositif holographique optique selon la revendication 1, dans lequel les éléments détecteurs (414a, 414b) sont disposés selon des rangées décalées, les moyens pour former une page de données représentée par une image étant disposés de façon qu'un bit de données représenté par une image affecte au moins deux éléments détecteurs.

5. Procédé pour lire une page de données enregistrée sur un support holographique, ledit procédé comprenant une étape de formation d'une page de données représentée par une image, à partir de ladite page de données, sur le moyen de détection, ladite page de données représentée par une image comprenant des bits de données, représentés par une image, possédant une première dimension dans une direction, **caractérisé en ce qu'**il y a au moins une étape de déplacement de la page de données représentée par une image par rapport au moyen de détection sur une distance correspondant à la première dimension, et, après chaque étape de déplacement, une étape de mesure de la sortie d'au moins un élément détecteur possédant une seconde dimension dans ladite direction, ladite seconde dimension étant plus grande que ladite première dimension, le procédé comprenant en outre une étape de récupération de la page de données à partir desdites mesures.

6. Procédé pour lire une page de données selon la revendication 5, ledit procédé comprenant en outre, après chaque étape de mesure, une étape de soustraction des sorties de deux éléments détecteurs.

7. Procédé pour lire une page de données selon la revendication 5, dans lequel ladite seconde dimension est X fois plus grande que ladite première dimension, le procédé comprenant (X-1) étapes de déplacement.

8. Programme d'ordinateur comprenant un jeu d'instructions qui, lorsqu'il est chargé dans un processeur ou un ordinateur, provoque la mise en oeuvre par le processeur ou l'ordinateur du procédé selon la revendication 5.
